# EUROPEAN PATENT APPLICATION

(11) **EP 2 385 352 A2**
(43) Date of publication of application: **09.11.2011**
(21) Application number: 11164946.3
(22) Date of filing: 05.05.2011
(51) Int. Cl.: G01D 4/00

(54) **Power monitoring apparatus for household appliance**

(30) Priority: 07.05.2010 KR 20100043172; 14.01.2011 KR 20110004203
(71) Applicant: Samsung Electronics Co., Ltd., Suwon-si, Gyeonggi-do 506-762 (KR)
(72) Inventor: Park, Young Jin, Gyeonggi-do (KR); Cho, Chi Hong, Gyeonggi-do (KR); Park, Hyun Soo, Seoul (KR); Won, Eun Tae, Seoul (KR); Hawng, Dong Yun, Seoul (KR); Bae, Tae Han, Seoul (KR); Lim, Hyoung Kyu, Seoul (KR); Jang, Jae Hwi, Gyeonggi-do (KR); Han, Se Hee, Seoul (KR)
(74) Representative: Grünecker, Kinkeldey, Stockmair & Schwanhäusser

(57) **Abstract**

A power monitoring apparatus is externally coupled to a household appliance so that the power monitoring apparatus can provide a communication function and a power metering function to the household appliance. As a result, the household appliance need not include the power monitoring apparatus, resulting in reduction in production costs of the household appliance.

## Description

### BACKGROUND

### 1. Field

Embodiments relate to a power monitoring apparatus for monitoring information about power consumed in a household appliance.

### 2. Description of the Related Art

With the development of Information Technology (IT), the number of electric household appliances is rapidly increasing, in turn leading to increased power demand.

In order to satisfy such power demand, the number of power plants is rapidly increasing.

However, as can be seen from a power demand pattern, peak capacity is not reached during most days of the year. More specifically, power plants only operate at full capacity during a few days out of the year.

A status in which a high power demand is required for a short time is called peak load. If an additional power plant is added to the grid to handle peak load, huge construction costs for the additional power plant are required, and maintenance costs for power plants constructed to maintain peak load for a short period are considerable.

Recently, many developers have conducted intensive research into a demand management method for temporarily restricting power consumption by limiting peak load without constructing such additional power plants.

For the aforementioned purposes, demand management is a focus of attention, and a great deal of research is focused upon an advanced demand management format for demand response (DR).

Demand response (DR) is a system for intelligently managing energy consumption depending upon variation in power rates.

For example, the consumer may temporarily stop an air-conditioner so as to reduce power consumption when power rates are high.

A demand response (DR) controller is required to control demand response (DR). The DR controller receives power rates from the power company in real time, and controls household appliances on the basis of the received power rates.

A household appliance installed in a home receives power rate information through the DR controller, and operates an internal control algorithm in response to the received power rate information, so that power consumption can be changed according to power rates. The above-mentioned function is called a demand response (DR) function, and the DR controller can maximize home energy efficiency by controlling the household appliance.

However, a communication module must be installed in the household appliance in such a manner that the household appliance can communicate with the DR controller.

In addition, the DR controller requires correct information about power consumption of each household appliance so as to control home energy usage, such that it is necessary for a power monitoring module to be installed in each household appliance.

Therefore, the household appliance must include the communication module and the power monitoring module, increasing production costs and making it difficult to guarantee sufficient installation space in the household appliance.

Furthermore, not all household appliances including the power monitoring module are interoperable with the DR controller. In case of an exemplary household appliance that is not interoperable with the DR controller and has only the power monitoring unit, this household appliance has high production costs due to the presence of unused functions, resulting in increased cost to consumers.

### SUMMARY

Therefore, it is an aspect of the present embodiments to provide a power monitoring apparatus externally coupled to a household appliance so that the power monitoring apparatus can provide the household appliance with a communication function and a power monitoring function.

It is another aspect of the present embodiments to provide a power monitoring apparatus that externally connects a communication module capable of providing a household appliance with a communication function to a communication port of the household appliance, and connects a power monitoring module capable of providing the household appliance with a power monitoring function to a power line assigned to a power outlet (i.e., socket) for the household appliance, such that power monitoring can be achieved at the power line.

Additional aspects will be set forth in part in the description which follows and, in part, will be apparent from the description, or may be learned by practice of the invention.

In accordance with one aspect of the present embodiments, a power monitoring apparatus includes a power connector coupled to a communication port of a household appliance; a communication module coupled to the communication connector so as to implement communication between the household appliance and an external device; a power connector coupled to a power port of the household appliance coupled to a power line of the household appliance; and a power monitoring module coupled to the power connector so as to monitor power of the household appliance on the basis of power provided to the household appliance.

The power port and the power connector may be connected through a power cable.

The power monitoring module may include a voltage sensing unit to sense a voltage provided to the household appliance; a current sensing unit to sense current provided to the household appliance; and a power controller to monitor power of the household appliance on the basis of the voltage sensed through the voltage sensing unit and the current sensed through the current sensing unit.

The voltage sensing unit may detect a voltage between both ends of the power cable.

The current sensing unit may be a current sensor that includes a resistor serially connected to any one of the AC power lines present in the power cable so as to sense a current flowing in the any one of the AC power lines.

The current sensing unit may be a CT current sensor included in the any one of AC power lines so as to detect a current flowing in the any one of the AC power lines present in the power cable.

The communication connector may include any one of a Universal Serial Bus (USB) connector, a Universal Asynchronous Receiver/Transmitter (UART) connector, a Serial Peripheral Interface (SPI) bus connector, an Inter Integrated circuit (12C) connector, and a 20-pin standard connector.

The communication module may include a transmission/reception unit to transmit/receive information to/from an external device, and a communication controller to control information transmission/reception with the external device through the transmission/reception unit.

The communication module may include a power source unit to provide power to the communication module, a power manager to monitor a power status of the power source unit and provide power status information on the basis of the monitored power status, and a switching unit to provide voltage to the power source unit or interrupt voltage from the power source unit, and the communication controller controls the switching unit when electricity needs to be supplied to the power source unit on the basis of the power status information provided from the power manager, thereby charging the power source unit.

The communication controller may control an operation for charging the power source unit before an operation of the household appliance is completed.

In accordance with another aspect of the present embodiments, a power monitoring apparatus includes a power connector coupled to a power port of a household appliance coupled to a power line of the household appliance; a power monitoring module coupled to the power connector so as to monitor power of the household appliance on the basis of power provided to the household appliance; a communication connector coupled to a communication port of the household appliance; and a communication module that is connected to the communication connector so as to communicate with the external device, wherein the communication module transmits household appliance power data monitored by the power monitoring module to the external device.

The power port and the power connector may be connected through a power cable.

The communication connector may include any one of a Universal Serial Bus (USB) connector, a Universal Asynchronous Receiver/Transmitter (UART) connector, a Serial Peripheral Interface (SPI) bus connector, an Inter Integrated circuit (12C) connector, and a 20-pin standard connector.

The household appliance may include a main relay switch for switching a power line, and the communication module turns on the main relay switch.

In accordance with another aspect of the present embodiments, a power monitoring apparatus includes a communication module that is externally coupled to a communication port of a household appliance and provides the household appliance with a communication function; and a power monitoring module that communicates with the communication module, monitors power provided to the household appliance through a power line of a power outlet for the household appliance, and transmits the monitored power information to the communication module.

The power monitoring module may be connected to the communication module by wire, such that the monitored power information is transmitted to the communication module by wire.

The power monitoring module may be configured in a form of tongs or clips so as to be connected to a power line of the household appliance.

The power monitoring module may include a current transformer for sensing voltage flowing in any one of power lines of the household appliance.

The power monitoring module and the communication module may be integrated into one element, and the communication port of the household appliance is located close to the power line of the power outlet of the household appliance.

The power monitoring module may be wirelessly connected to the communication module so that the monitored power information is wirelessly transmitted to the communication module.

The power monitoring module may be configured as a socket coupled to a power plug of the household appliance.

The power monitoring module may include a current sensing unit to sense a voltage flowing in a power line of the household appliance, and a voltage sensing unit to sense a voltage between both ends of the power line.

In accordance with another aspect of the present embodiments, a power monitoring apparatus includes a communication connector coupled to a communication port of a household appliance; a communication module coupled to the communication connector so as to wirelessly communicate with an external device; and a power monitoring module that monitors power information provided to the household appliance through a power line of the household appliance coupled to a power outlet, and is connected to the communication module by wire or wirelessly so that the monitored power information is transmitted to the external device through the communication module.

In accordance with another aspect of the present embodiments, a power monitoring apparatus includes a communication module that is externally coupled to a communication port of a household appliance and provides the household appliance with a communication function, and a power monitoring module that wirelessly communicates with the communication module, monitors power provided to the household appliance through a power line of a power outlet for the household appliance, and wirelessly transmits the monitored power information to the communication module, wherein the power monitoring module receives a unique number for communication with the communication module when communication between the power monitoring module and the communication module is registered, and stores the received unique number, the communication between the power monitoring module and the communication module being achieved by the communication module that authenticates the unique number of the power monitoring module.

The communication module may include a sensor for detecting approaching of the power monitoring module, wherein if the approaching of the power monitoring module is detected by the sensor, the unique number is automatically transmitted to the power monitoring module.

Each of the communication module and the power monitoring module may include a button, and if the buttons of the communication module and the power monitoring module are pressed, the communication module may transmit the unique number and the power monitoring module may store the transmitted unique number.

In accordance with another embodiment, a method of monitoring power of a household appliance includes detecting, by a power monitoring apparatus externally coupled to the household appliance, an amount of power consumed by the household appliance, and transmitting, by the power monitoring apparatus, the detected amount of power to a demand response unit.

The method of monitoring power of a household appliance may further include receiving, by the power monitoring apparatus, a request from the demand response unit and transmitting the detected amount of power to the demand response unit in response to the request.

Further, the method of monitoring power of a household appliance may also include transmitting, by the power monitoring apparatus, the detected amount of power to the household appliance.

### BRIEF DESCRIPTION OF THE DRAWINGS

These and/or other aspects of the invention will become apparent and more readily appreciated from the following description of the embodiments, taken in conjunction with the accompanying drawings of which:
FIG. 1 is a configuration diagram illustrating a demand response (DR) system applied to a power monitoring apparatus according to an embodiment.
FIG. 2 is a structural diagram illustrating a power monitoring apparatus according to an embodiment.
FIG. 3 is a structural diagram illustrating that the power monitoring apparatus is externally coupled to a household appliance according to an embodiment.
FIG. 4 shows the relationship between a communication module and a power monitoring module shown in FIG. 2.
FIG. 5 is a control block diagram illustrating a power monitoring apparatus according to an embodiment.
FIG. 6 is a perspective view illustrating a power monitoring apparatus externally coupled to a household appliance according to an embodiment.
FIG. 7 is a control block diagram illustrating the sensing and transmitting of power by the power monitoring apparatus according to an embodiment.
FIG. 8 is a perspective view illustrating a power monitoring apparatus externally coupled to a household appliance according to another embodiment.
FIG. 9 is a control block diagram illustrating the sensing and transmitting of power by the power monitoring apparatus according to another embodiment.
FIG. 10 shows the coupling structure of the power monitoring apparatus according to still another embodiment.
FIG. 11 is a structural diagram illustrating a power monitoring apparatus according to still another embodiment.
FIG. 12 is a structural diagram illustrating a power monitoring apparatus according to still another embodiment.
FIG. 13 is a control block diagram illustrating a power monitoring apparatus according to an embodiment.
FIG. 14 is a structural diagram illustrating a power monitoring apparatus according to still another embodiment.
FIG. 15 is a structural diagram illustrating a power monitoring apparatus according to still another embodiment.
FIG. 16 is a structural diagram illustrating a power monitoring apparatus according to still another embodiment.
FIG. 17 is a structural diagram illustrating a power monitoring apparatus according to still another embodiment.
FIG. 18 is a control block diagram illustrating a power monitoring apparatus according to an embodiment.
FIG. 19 is a structural diagram illustrating a power monitoring apparatus according to still another embodiment.
FIG. 20 is a control block diagram illustrating a power monitoring apparatus according to an embodiment.

### DETAILED DESCRIPTION

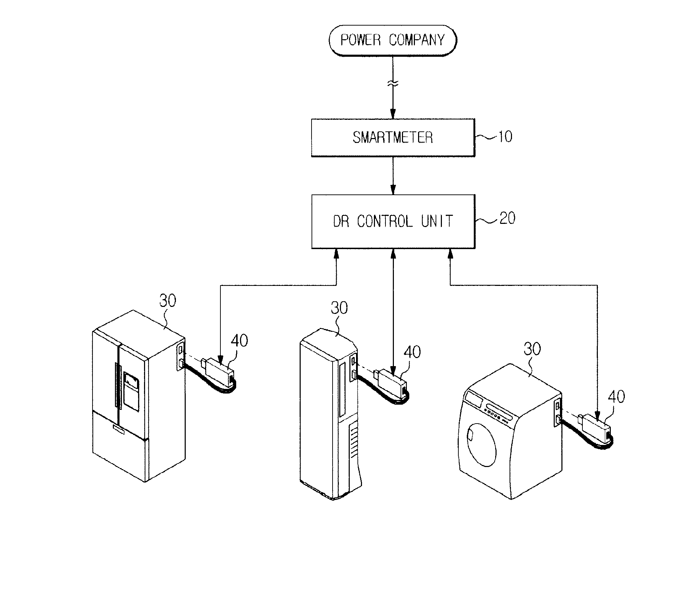

Reference will now be made in detail to the embodiments, examples of which are illustrated in the accompanying drawings, wherein like reference numerals refer to like elements throughout. FIG. 1 is a configuration diagram illustrating a demand response (DR) system applied to a power monitoring apparatus according to an embodiment.

Referring to FIG. 1, the DR system including the power monitoring apparatus includes a smartmeter 10 installed in a home to transmit and receive information to and from a power company; a DR control unit 20 to receive information about electric charges from the smartmeter 10; and a plurality of household appliances 30 connected to the DR control unit 20.

The household appliance performs a desired function using power received through a power line.

The household appliance 30 may include all kinds of electric household appliances, for example, a refrigerator, an air-conditioner, a washing machine, a stove (cook top), a television, etc.

Power consumption of the household appliance 30 is measured by the power monitoring apparatus 40.

The power monitoring apparatus 40 includes a communication function and a power metering function, and is externally connected to the household appliance 30. The power monitoring apparatus 40 detects actual power consumption of the household appliance, and transmits information about the detected power consumption to the DR control unit 20 or the household appliance 30 or both.

The power monitoring apparatus 40 detects the actual power consumption of the household appliance 30 and informs the DR control unit 20 of the detected power consumption.

The DR control unit 20 determines a DR level on the basis of specific information (e.g., power rate information), and transmits the DR level to the household appliance 30.

The DR control unit 20 receives power rate information from a power company through the smartmeter 10 at intervals of a unit time, and establishes different DR levels having different power rates using the received power rate information.

The DR level may include several levels, such as 4 levels (first to fourth DR levels), each having different power rates and different allowable power amounts. In an example, the higher the DR level, the higher the power rate. The established DR level information is transmitted to the household appliance 30.

The DR control unit 20 recognizes a current DR level of the household appliance 30, and measures power consumption of the household appliance 30 using the power monitoring apparatus 40.

The DR control unit 20 compares measured power consumption with allowed power consumption corresponding to a current DR level. If the power consumption is identical to or higher than the allowed power consumption, the DR control unit 20 delays an operation start time point of individual loads in ascending numerical order of priority until current power consumption reaches the allowed power consumption. If the current power consumption is less than the allowed power consumption, individual loads are operated normally in a predetermined operation order.

By the above-mentioned scheme, power consumption is reduced in a period of a high DR level, resulting in a reduction in power rate.

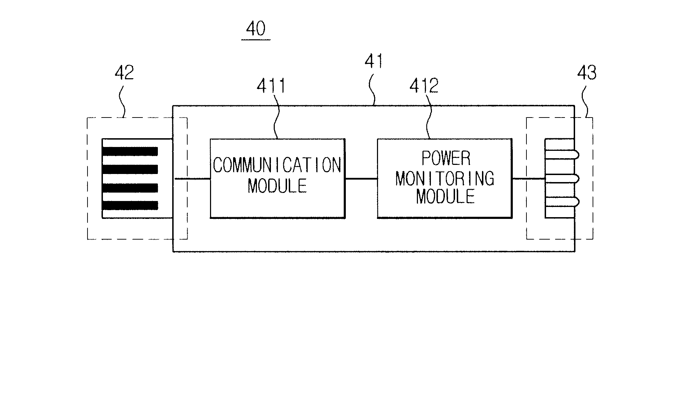

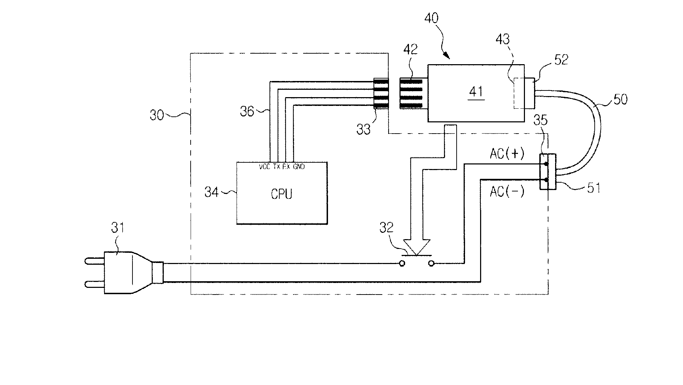

FIG. 2 is a structural diagram illustrating a power monitoring apparatus according to an embodiment. FIG. 3 is a structural diagram illustrating that the power monitoring apparatus is externally coupled to a household appliance according to an embodiment.

Referring to FIG. 2, the power monitoring apparatus 40 includes a main body 41, a communication connector 42 mounted to a front part of the main body 41 so that it is connected to a communication port of the household appliance 30, and a power connector 43 mounted to a rear part of the main body 41 so that it is connected to a power port of the household appliance 30 through a power cable.

The main body 41 includes a communication module 411 connected to the communication connector 42 so as to communicate with a household appliance or an external device. In the embodiment, the communication module 411 performs the communication function.

The main body 41 includes a power monitoring module 412 connected to the power connector 43 to measure household appliance power supplied from a power source to the household appliance. In the embodiment, the power monitoring module 412 performs the power metering function.

The communication module 411 and the power monitoring module 412 are configured to communicate with each other.

In an embodiment, if a communication function is not required, the power monitoring module 412 alone may be provided.

The communication connector 42 is used as a signal line to transmit and receive a variety of control signals to and from the household appliance 30. The communication connector 42 may be based on a universal serial bus (USB) connector, and may also be implemented using a standard 20-pin connector for use in mobile phones, for example. However, although the communication connector 42 includes a USB-type connector, the scope or spirit of the communication connector 42 is not limited to a USB high-speed communication scheme. That is, the communication scheme for transmitting and receiving information through the communication connector 42 may be any one of a Universal Asynchronous Receiver/Transmitter (UART), a Serial Peripheral Interface (SPI) bus, an Inter Integrated Circuit (12C), etc.

The power connector 43 is used to measure power consumed by the household appliance 30, and is coupled to a power port of the household appliance 30. The power port is an AC power port. If the household appliance 30 is operated by DC power, a DC power port may also be used as the power port of the household appliance 30. In this case, the number of pins of the power connector 43 is changed according to a scheme for allowing the power monitoring apparatus 40 to detect voltage and current signals of the household appliance 30. Specifically, the number of pins is changed according to a current detection scheme. When a current detection method based upon resistance is used, the number of pins is 3. In the case of using a current detection scheme based on a current transformer (CT), the number of pins is 4.

FIG. 3 is a structural diagram illustrating that the power monitoring apparatus 40 is externally coupled to a household appliance according to an embodiment.

Referring to FIG. 3, the communication connector 42 of the power monitoring apparatus 40 (or power metering unit) is directly connected to a communication port 33 connected to a CPU 34 for overall control of the household appliance 30. The power connector 43 is connected to a power port 35 connected to AC power lines (AC(+) and AC(-)) of the household appliance 30 through a power cable 50.

Two connectors 51 and 52 are respectively located at both ends of the power cable 50.

A signal line 36 is connected between the CPU 34 and the communication port 33. There are a variety of signal lines, for example, VCC, TX, RX, and GND. TX and RX are used for data communication between the CPU 34 and the power monitoring apparatus 40, and VCC and GND are used to provide the power monitoring apparatus 40 with power.

A plug 31 is connected to one side of the AC power lines (AC(+) and AC(-)) of the household appliance 30.

A main relay switch 32 is connected to one of the AC power lines (AC(+) and AC(-)). The main relay switch 32 may be configured to be powered on or off not only by the CPU 34 but also by the power monitoring apparatus 40.

The power monitoring apparatus 40 includes a battery. Thus, even if the household appliance 30 is completely powered off (i.e., although the main relay switch 32 is turned off and power is not supplied to the household appliance 30), the power monitoring apparatus 40 switches on the main relay switch 32 of the household appliance 30 using battery power, so that it can power on the household appliance 30.

For this operation, the power monitoring apparatus 40 includes a circuit for driving the main relay switch 32 of the household appliance 30. The circuit is a closed circuit in which the power connector 43 is connected to the power port 35 of the household appliance 30 through the power cable 50.

Through the above-mentioned circuit configuration, the household appliance 30 need not stay in a standby mode to receive an external signal, resulting in reduction in standby power.

The battery of the power monitoring apparatus 40 checks its own level of charge during operation of the household appliance 30, and is then fully charged at a specific time at which battery charging is needed or just before the main relay switch is turned off.

When the household appliance 30 is completely powered off, the power monitoring apparatus 40 is operated in a power saving mode to conserve the charge of the battery.

In more detail, the household appliance 30 includes a DR-associated algorithm to perform DR control. In order to operate the DR-associated algorithm, the household appliance 30 needs to transmit and receive a variety of information to and from the DR control unit 20. In order to measure the power of the household appliance 30, a communication module and a power monitoring module are required.

If the household appliance 30 includes the communication module and the power monitoring module, production costs for the communication module and the power monitoring module are further required, so that it is preferable that the communication module or the power monitoring module be configured as an external-type module.

Thus, in accordance with the embodiment, the communication module and the power monitoring module are installed in the power monitoring apparatus 40 that is externally coupled to the household appliance 30.

As a result, the embodiment can measure power of the household appliance 30 and can transmit power data to the DR control unit 20. The household appliance 30 can receive a DR level or various control commands from the DR control unit 20 through the power monitoring apparatus 40.

The CPU 34 may optimally control the household appliance in response to a DR level, or may control the household appliance in response to various control commands.

Meanwhile, in order to fully power down the household appliance 30, the CPU 34 switches off the main relay switch 32 contained in a main board when the household appliance 30 is not operated, so that it can eliminate standby power consumption of the household appliance 30 when the plug 31 is in a socket.

In this case, in order for the household appliance 30 to be normally re-operated by an external command, the main relay switch 32 must be turned on by the power monitoring apparatus 40.

Upon receiving a turn-ON signal from the DR control unit 20, the power monitoring apparatus 40 can wake the CPU 34 by switching on the main relay switch 32 using battery power.

For this operation, the power monitoring apparatus 40 includes a battery. While the main relay switch 32 is on, the power monitoring apparatus 40 charges the battery with power received through the main relay switch 32. While the main relay switch 32 is off, the power monitoring apparatus 40 can be driven by power stored in the battery (hereinafter referred to as a power source).

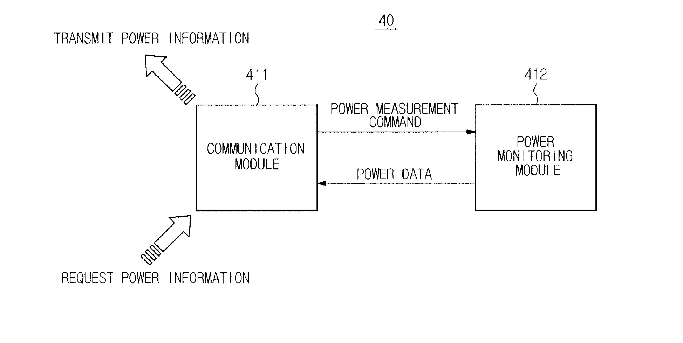

FIG. 4 shows the relationship between a communication module 411 and a power monitoring module 412 shown in FIG. 2.

Referring to FIG. 4, the communication module 411 transmits a power measurement command to the power monitoring module 412 upon receiving a power information request from the DR control unit 20.

The power monitoring module 412 measures power of the household appliance 30, and transmits power data to the communication module 411.

The communication module 411 transmits power information to the DR control unit 20 on the basis of the power data.

The communication module 411 may provide the household appliance 30 with a command or information received from the DR control unit 20 according to a serial communication scheme, such as USB, SPI, or I2C, etc.

In addition, the communication module 411 may be comprised of several communication modules such that it can switch between various communication schemes such as ZIGBEE, Wl-FI, and power line communication (PLC) or in response to environments.

The PLC chip has high production costs due to technical difficulty in fabrication thereof. In the case of using the power monitoring apparatus 40 externally coupled to the household appliance according to the present invention, it is not necessary for the PLC chip to be installed in all household appliances, resulting in a reduction in production costs.

In compliance with communication chip standardization, ZIGBEE communication is available when a ZIGBEE chip is connected to the power monitoring apparatus 40. If a WI-FL chip is connected to the power monitoring apparatus 40, WI-FL communication is possible, so that the power monitoring apparatus 40 can support a variety of communication schemes. For reference, power line communication based on the PLC chip is achieved through the AC power line connected to the power connector 43.

The communication module 411 may demodulate an analog RF signal received through an antenna into a digital signal, or may modulate a digital signal to be transmitted into an analog RF signal.

The power monitoring module 412 may monitor or measure the power of the household appliance 30 in response to a current measurement command received from the communication module 411.

The power monitoring module 412 detects a voltage between both ends of the AC power line of the power port 35 connected to the power connector 43. The power monitoring module 412 detects current flowing in any one of the AC power lines, so that it can calculate power data of the household appliance 30. If necessary, the power monitoring module 411 may transmit a voltage value and a current value other than the power value to the communication module 411.

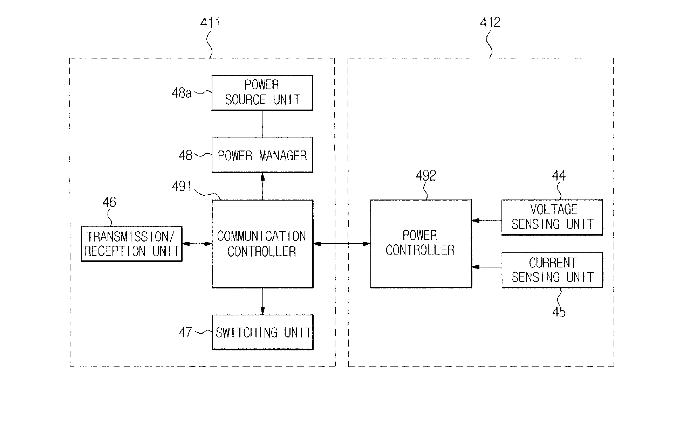

FIG. 5 is a control block diagram illustrating a power monitoring apparatus according to an embodiment.

Referring to FIG. 5, the power monitoring apparatus 40 according to the embodiment may include a voltage sensing unit 44, a current sensing unit 45 and a power controller 492.

The voltage sensing unit 44 may detect a voltage of the household appliance 30 using an AC power line connected to the power connector 43. The voltage sensing unit 44 may detect a voltage between both ends of the AC power line.

The current sensing unit 45 may detect a current of the household appliance 30 using any one of the AC power lines connected to the power connector 43.

In addition, the current sensing unit 45 includes a current sensor composed of a magnetic core and a coil. The current sensor measures electromotive force (EMF) generated in a coil wound on the magnetic core, so that it can detect an AC current on the basis of the measured EMF. Most current sensors are implemented as Conductivity-Temperature (CT) sensors.

In addition, the current sensing unit 45 includes a current sensor comprised of one or more resistors serially connected to any one of AC power lines. This current sensor measures a voltage between both ends of the resistor, so that it can detect the AC current.

The power controller 492 monitors (or measures) power of the household appliance 30 in response to a current measurement command received from the communication controller 491.

The power controller 492 detects a voltage between both ends of the AC power line connected to the power connector 43 using the voltage sensing unit 44, and detects current flowing in any one of AC power lines connected to the power connector 43, so that it calculates power consumption data of the household appliance. In this case, the power controller 492 may transmit a current value and a voltage value instead of the power value to the communication controller 491.

The power monitoring apparatus 40 according to the embodiment may include a communication module 411. The communication module 411 includes a transmission/reception unit 46, a switching unit 47, a power manager 48, a power source unit 48a, and a communication controller.

The transmission/reception unit 46 includes an antenna. The antenna may be implemented as a PCB-type antenna for increasing wireless communication reliability such as a WI-FI or ZIGBEE.

The switching unit 47 may provide voltage to the power source unit 481 upon receiving a control signal from the communication controller 491, or may block the voltage provided to the power source unit 48a.

The power manager 48 measures a power status of the power source unit 48a upon receiving a control signal from the communication controller 491, and outputs power status information to the communication controller 491 on the basis of the measured power status. For example, the power manager 48 checks the charge level of the power source unit 48a to determine whether pr mpt the power source unit 48a is fully charged, and informs the controller 49 of the determined result.

The power source unit 48a provides power to drive the power monitoring apparatus 40. The power source unit 48a may be any one of a rechargeable battery, an alkaline battery, a button cell, or a fuel cell.

The power monitoring apparatus 40 includes the power source unit 48a. As such the household appliance 300 need not maintain a standby mode to receive an output signal of the power monitoring apparatus 40, resulting in a reduction in standby mode power consumption of the household appliance 30.

The power monitoring apparatus 40 wakes the household appliance 30 only when the power source unit 48a needs to be charged, and thus charges the power source unit 48a with electricity, resulting in reduction in standby power consumption of the household appliance 30. In addition, the communication controller 491 charges the power source unit 48a with electricity. The communication controller 491 measures a power status of the power source unit 48a using the power manager 48. If the power source unit 48a needs to be charged, the communication controller 491 turns the switching unit 47 on so as to provide the power source unit 48a with power. Once the power source unit 48a is fully charged, the communication controller 491 turns the switching unit 47 off so as to prevent power from flowing to the power source unit 48a. Therefore, the household appliance 30 need not maintain the standby mode to receive a signal from the power monitoring apparatus 40, so that it can reduce the standby mode power consumption of the household appliance 30.

The communication controller 491 transmits a power measurement command to the power controller 492 in response to a power information request received from the DR control unit 20, and receives power data from the power controller 492. The communication controller 491 transmits power information to the DR control unit 20 on the basis of the power data.

In addition, the communication controller 491 may provide a command or information received from the DR control unit 20 to the connected household appliance 30 using a serial communication scheme such as USB, SPI, 12C, etc.

In addition, the communication controller 491 may demodulate an analog RF signal received through an antenna into a digital signal, or may modulate a digital signal to be transmitted into an analog RF signal.

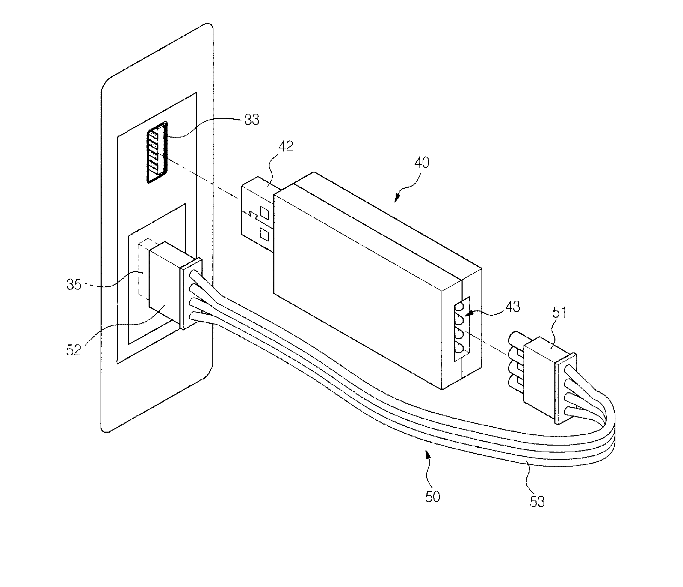

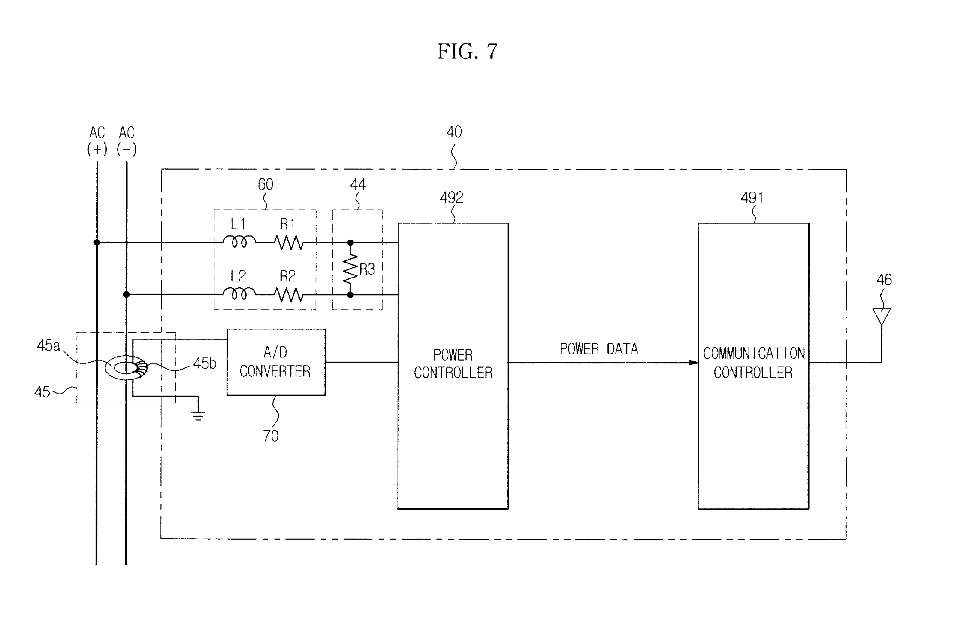

FIG. 6 is a perspective view illustrating a power monitoring apparatus externally coupled to a household appliance according to an embodiment. FIG. 7 is a control block diagram illustrating measurement and transmission of power by the power monitoring apparatus according to an embodiment.

Referring to FIG. 6, in order to externally couple the power monitoring apparatus 40 to the household appliance 30, it is necessary for the communication connector 42 of the power monitoring apparatus 40 to be coupled to the communication port 33 of the household appliance 30.

As a result, the household appliance 30 can communicate with an external part through a communication function of the power monitoring apparatus 40.

In addition, the power connector 43 of the power monitoring apparatus 40 is coupled to the power port 35 of the household appliance 30 through the power cable 50. A first connector 51 of the power cable 50 is coupled to the power connector 43 of the power monitoring apparatus 40, and a second connector 52 of the power cable 50 is coupled to the power port 35 of the household appliance 30. For example, if the current sensing unit 45 is implemented as a CT current sensor, the number of power cables 50 may be set to 4.

By the above-mentioned connection, the AC power line of the household appliance is connected to the power monitoring apparatus 40, so that it is possible to measure the power of the household appliance 30.

Referring to FIG. 7, the voltage sensing unit 44 of the power monitoring apparatus 40 includes a resistor R3 serially connected between AC power lines (AC(+) and AC(-)).

An LR circuit denoted by reference numeral 60 is adapted to reduce voltage level applied to the voltage sensing unit 44. The power controller 492 detects a voltage of the household appliance 30 by sensing a voltage between both ends of the resistor R3.

The current sensing unit 45 of the power monitoring apparatus 40 includes a magnetic core 45a and a coil 45b. One of the AC power lines (AC(+) and AC(-)) passes through the magnetic core 45a, and the coil 45 is wound on one side of the magnetic core 45a.

Therefore, the alternating current flowing in the AC power line (AC(-)) passing through the magnetic core 45a generates concentric magnetic flux in the vicinity of the AC power line (AC(-)). The magnetic flux passes through the magnetic core 45a passing through the AC power line (AC(-)).

In this case, the magnetic flux induced by the AC signal is a time-variant magnetic flux, such that induced electromotive force occurs in the coil 45b according to the laws of electromagnetic induction. The induced electromotive force is converted into a digital value by an Analog-to-Digital (A/D) converter 70, and the converted result is transmitted to the power controller 492.

The power controller 492 calculates a value of the AC signal flowing in the AC power line (AC(-)) on the basis of the digital value. In this way, the power controller 492 detects a current of the household appliance 30 through the current sensing unit 45.

The power controller 492 calculates power data using a voltage detected by the voltage sensing unit 44 and a current detected by the current sensing unit, and transmits the calculated power data to the communication controller 491. The communication controller 491 transmits the power data to the DR control unit 20 through the transmission/reception unit 46.

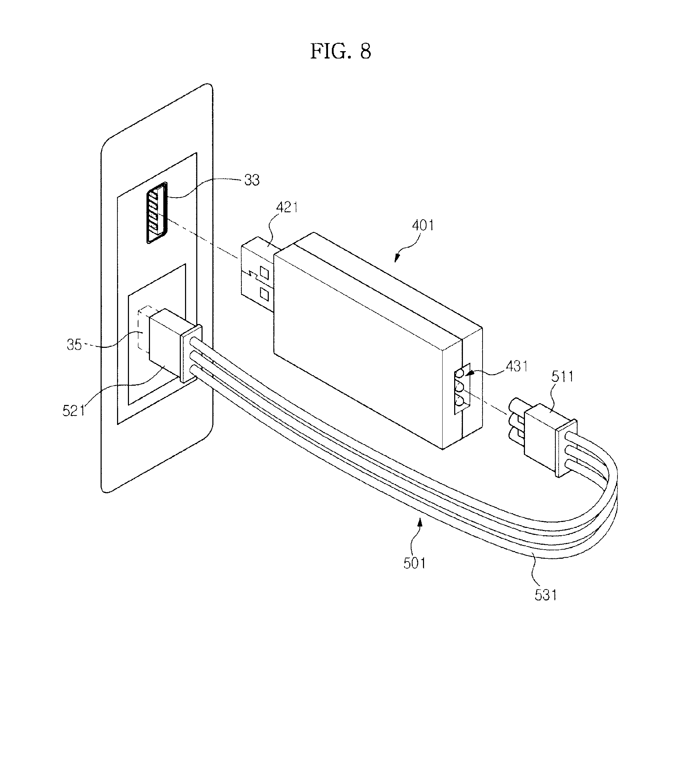

FIG. 8 is a perspective view illustrating a power monitoring apparatus externally coupled to a household appliance according to another embodiment.

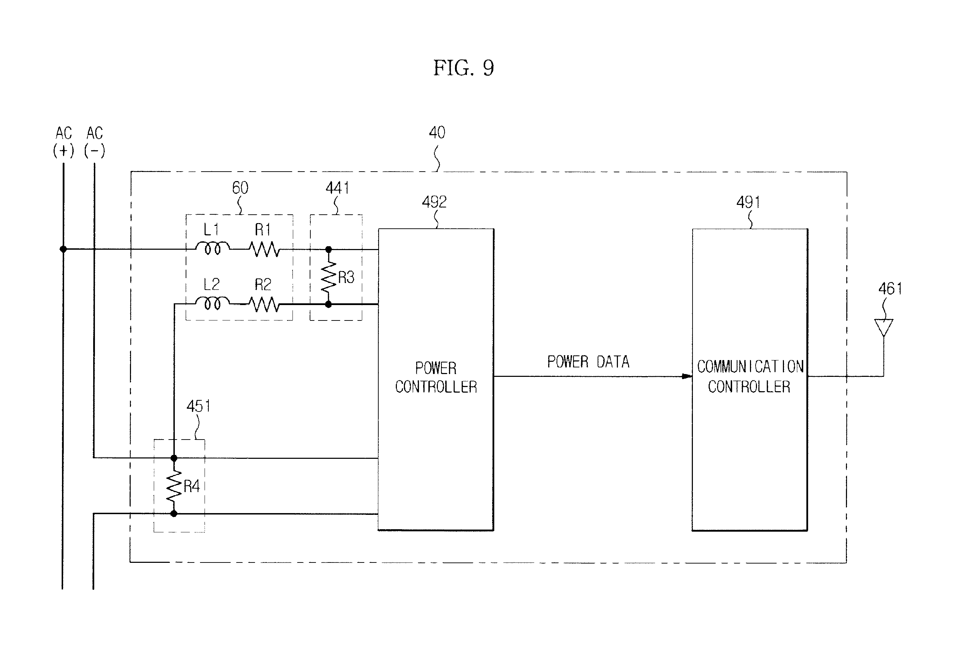

FIG. 9 is a control block diagram illustrating sensing and transmission of power by the power monitoring apparatus according to another embodiment.

In the embodiment of FIG. 8, the power monitoring apparatus 40 is referred to as power metering unit 401. Referring to FIG. 8, a communication connector 421 of the power metering unit 401 is connected to the communication port 33 of the household appliance 30, and the power connector 431 of the power metering unit 401 (power monitoring apparatus 40) is connected to the power port 35 of the household appliance 30 through the power cable 501.

In the embodiment of FIG. 8, if the current sensing unit 45 is a resistive-type current sensor, the number of the power cable lines 501 is exemplarily set to 3.

By the above-mentioned connection, the household appliance 30 can communicate with an external part using a communication function of the power monitoring apparatus 40. The AC power line of the household appliance 30 is connected to the power monitoring apparatus 40, so that the power of the household appliance 30 can be measured.

Referring to FIG. 9, the voltage sensing unit 441 of the power monitoring apparatus 40 (power metering unit 401) includes a resistor R3 serially connected between the AC power lines (AC(+) and AC(-)). The LR circuit denoted by reference numeral 60 is used to reduce voltage applied to the voltage sensing unit 441.

The power controller 492 detects a voltage generated between both ends of the resistor R3 so as to detect a voltage of the household appliance 30.

In addition, the current sensing unit 45 of the power monitoring apparatus 40 includes a resistor R4 serially connected to one (AC(-)) of the AC power lines (AC(+) and AC(-)). The power controller 492 can detect a current of the household appliance 30 by sensing a voltage between both ends of the resistor R4.

The power controller 492 calculates power data using voltage detected by the voltage sensing unit 44 and current detected by the current sensing unit, and transmits the calculated power data to the communication controller 491.

The communication controller 491 transmits the power data to the DR control unit 20 through the transmission/reception unit 461.

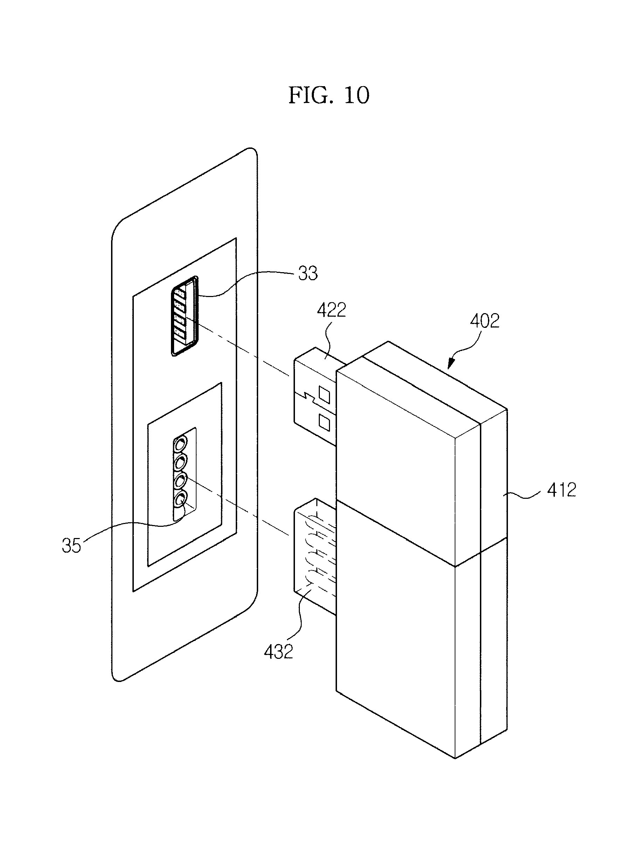

FIG. 10 shows the coupling structure of the power monitoring apparatus according to still another embodiment.

In the embodiment of FIG. 10, the power monitoring apparatus 40 is referred to as power monitoring apparatus 402. Referring to FIG. 10, the communication connector 422 of the power monitoring apparatus 402 and the power connector 432 may also be disposed at the same surface from among several surfaces of the main body 412.

As a result, the power connector 432 can be directly coupled to the power port 35 of the household appliance 30 without using the power cable, and can closely adhere to the household appliance 30.

The above-mentioned power monitoring apparatus according to embodiments connects a communication connector to a communication port of the household appliance, and at the same time directly connects a power connector to a power port of the household appliance or connects between the power connector and the power port of the household appliance through a power cable in such a manner that the power monitoring apparatus can be connected to the household appliance.

Therefore, the operation for connecting the power connector of the power monitoring apparatus to the power port of the household appliance that receives a power-supply voltage as an input is indispensable, such that the installation engineer needs to install the power monitoring apparatus into the household appliance to ensure user safety and convenience.

In addition, in order for the power monitoring apparatus to monitor power consumption of the household appliance, a power line provided to the inside of the household appliance needs to be coupled to the power port, such that additional components and spaces are needed for the power monitoring apparatus. Since the above-mentioned power monitoring apparatus can be applied only to a household appliance having the above-mentioned structure, the models of available household appliances may be limited, such that the above-mentioned structure must be considered when designing of the household appliance.

Accordingly, the power monitoring apparatus according to still another embodiment is configured to monitor power at a power line of a household appliance coupled to a power outlet (i.e., socket) through a power code, instead of monitoring power by connecting the power monitoring module to the power port of the household appliance.

For the above-mentioned configuration, the power monitoring apparatus according to still another embodiment includes a communication module that is connected to a communication port of a household appliance so as to provide a communication function, and a power monitoring module for monitoring power of a household appliance through a power line of the household appliance coupled to a wall socket and transmits the monitored power information to the communication module by wire or wirelessly.

Briefly, the above-mentioned scheme separates the power monitoring module from a main frame (or main body) of the power monitoring apparatus, and arranges the separated power monitoring module at the power line of the household appliance. Accordingly, an additional power line need not be constructed in the household appliance, so that a power port of the household appliance, a power connector of the power monitoring apparatus, and the power cable for interconnection between the power port and the power connector of the household appliance can be removed. Thus, the above-mentioned scheme can monitor power of the household appliance without changing the structure of the household appliance.

In addition, the power monitoring module is configured in the form of tongs or clips widely used in a current transformer, or is configured in the form of a socket coupled to a power code of the household appliance in such a manner that the user can easily and safely connect the power monitoring module to the household appliance without the help of an engineer, thereby increasing user safety and convenience.

A power monitoring module for monitoring power of a household appliance through a power line of the household appliance coupled to a socket and at the same time transmitting monitored power information of the household appliance to the communication module can be largely classified into the following first and second schemes.

In the first scheme, the power monitoring module is connected to the communication module by wire. In this case, the power monitoring module may be configured in the form of tongs or clips, and is coupled to the power line of the household appliance. The power monitoring module is configured to detect either current flowing in the power line of the household appliance or voltage between both ends of the power source of the household appliance, such that it can monitor or measure power consumption of the household appliance. The power information monitored (or measured) by the power monitoring module is transmitted to the communication module through a communication line that connects the power monitoring module to the communication module.

In the second scheme, the power monitoring module is wirelessly connected to the communication module. The power monitoring module is configured in the form of a power outlet to which the power code of the household appliance is connected. In this case, the power monitoring module connected to the power code is connected to the power outlet. The power monitoring module monitors (or measures) power by detecting either current flowing in the power line of the household appliance or voltage between both ends of the power source of the household appliance. The power information monitored (or measured) by the power monitoring module is wirelessly transmitted to the communication module.

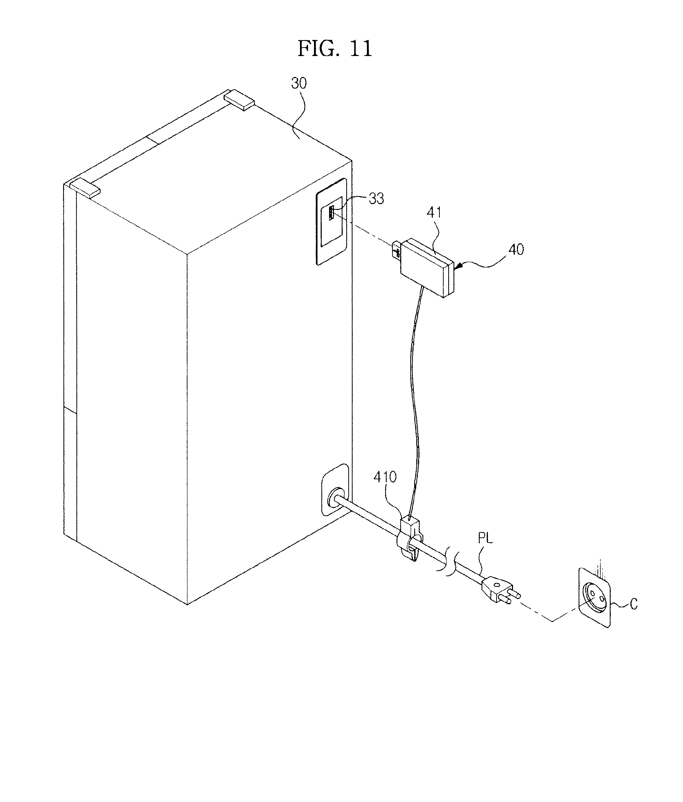

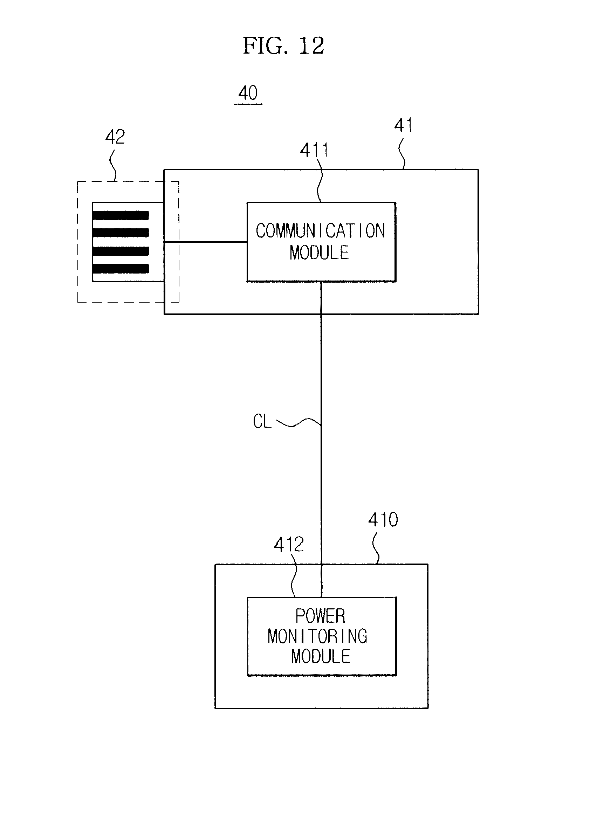

FIG. 11 is a structural diagram illustrating a power monitoring apparatus according to still another embodiment. FIG. 12 is a structural diagram illustrating a power monitoring apparatus according to still another embodiment.

Referring to FIGS. 11 and 12, the power monitoring apparatus 40 includes a main frame 41, a communication connector 42, and a communication module 411. The communication connector 42 is mounted to the front part of the main frame 41 such that it can be connected to the communication port 33 of the household appliance 30. The communication module 411 is connected to the communication connector 42 so as to communicate with the household appliance or the external device.

The communication connector 42 is used as a signal line to transmit and receive a variety of control signals to and from the household appliance 30. The communication connector 42 may be based on a universal serial bus (USB) connector, and may also be implemented with a 20-pin standard connector for use in mobile phones. However, although the communication connector 42 includes a USB-type connector, the scope or spirit of the communication connector 42 is not limited to a USB high-speed communication scheme. That is, the communication scheme for transmitting and receiving information through the communication connector 42 may be any one of a Universal Asynchronous Receiver/Transmitter (UART), a Serial Peripheral Interface (SPI) bus, an Inter Integrated Circuit (I2C), etc.

In addition, the power monitoring module for monitoring (or measuring) power of the household appliance using a power source signal provided to the household appliance 30 is connected to the communication line (CL). In this case, the power monitoring module 412 receives the power source signal through the communication line (CL). Therefore, power information of the household appliance measured by the power monitoring module 412 is transmitted to the communication module 411 through the communication line (CL). The communication module 411 is connected to the power monitoring module 412 such that it can communicate with the power monitoring module 412.

The power monitoring module 412 may be configured in the form of tongs or clips, and is coupled to a power line (PL) of the household appliance 30. The power monitoring module 412 is configured to detect either a current signal flowing in the power line (PL) of the household appliance 30 or a voltage signal between both ends of the power source of the household appliance 30, such that it can monitor or measure power of the household appliance 30. The power information monitored (or measured) by the power monitoring module 412 is transmitted to the communication module 411 through a communication line (CL).

In order to connect the power monitoring apparatus 40 to the household appliance 30, the communication connector 42 of the power monitoring apparatus 40 is coupled to the communication port 33 of the household appliance 30, and the power monitoring module 412 configured in the form of tongs or clips is coupled to the power line (PL) of the household appliance 30.

By the above-mentioned connection, the household appliance 30 can communicate with an external part through a communication module 411 of the power monitoring apparatus 40, and the power monitoring module 412 of the power monitoring apparatus 40 is coupled to the power line (PL) of the household appliance 30, so that the power consumption of the household appliance 30 can be measured.

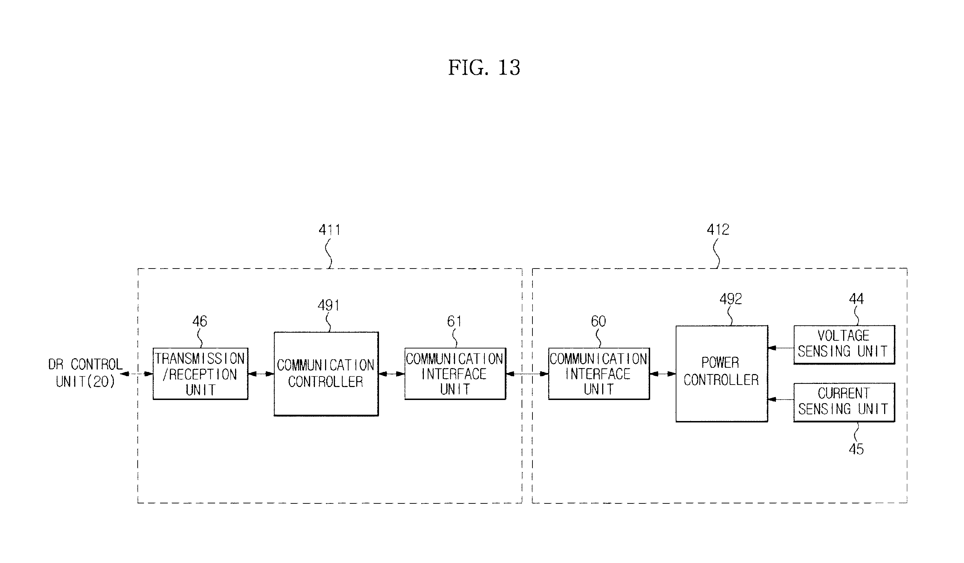

FIG. 13 is a control block diagram illustrating a power monitoring apparatus according to an embodiment.

Referring to FIG. 13, the power monitoring apparatus 40 includes a communication module 411, a power monitoring module 412, and a communication module 411.

The power monitoring module 412 includes a voltage sensing unit 44, a current sensing unit 45, a communication interface unit 60 and a power controller 492.

The voltage sensing unit 44 may detect a voltage between both ends of the power line (PL) of the household appliance 30.

The current sensing unit 45 may detect a current of the household appliance 30 using any one of two lines (AC- and AC+) of the power line (PL) of the household appliance 30. The current sensing unit 45 includes a current sensor composed of a magnetic core and a coil. The current sensor measures electromotive force (EMF) generated in a coil wound on the magnetic core, so that it can detect an AC current on the basis of the measured EMF. Most current sensors are implemented as Conductivity-Temperature (CT) sensors.

The communication interface unit 60 supports wired communication between the power controller 492 and the communication controller 491.

The power controller 492 receives the power monitoring command from the communication controller 491 through the communication interface unit 60, and monitors (or measures) power of the household appliance 30 using the received power monitoring command.

The power controller 492 detects a voltage between both ends of the power line (PL) of the household appliance 30 using the voltage sensing unit 44, and detects a current flowing in any one of power lines (PLs) of the household appliance 30, so as to calculate power data of the household appliance. In this case, the power controller 492 does not detect known data from among current and voltage values, and detects only unknown data, so that it can calculate power data on the basis of the detected unknown result. The power controller 492 may also transmit a current value and a voltage value instead of a power value to the communication controller 491.

The communication module 411 includes a transmission/reception unit (also called a transceiver) 46, a communication interface unit 61, and a communication controller 491.

The transmission/reception unit 46 includes an antenna. The antenna may be implemented as a PCB-type antenna for increasing wireless communication reliability such as a WI-FI orZIGBEE.

The communication interface unit 61 supports wired communication between the power controller 491 and the communication controller 492.

The power controller 491 transmits a power monitoring command to the power controller 492 upon receiving a power information request from the DR control unit 20, and receives power data from the power controller 492. The communication controller 491 transmits power information to the DR control unit 20 on the basis of the power data.

In addition, the communication controller 491 may provide the household appliance 30 with a command or information received from the DR control unit 20 according to a serial communication scheme, such as USB, SPI, or I2C, etc.

The communication controller 491 may demodulate an analog RF signal received through an antenna into a digital signal, or may modulate a digital signal to be transmitted into an analog RF signal.

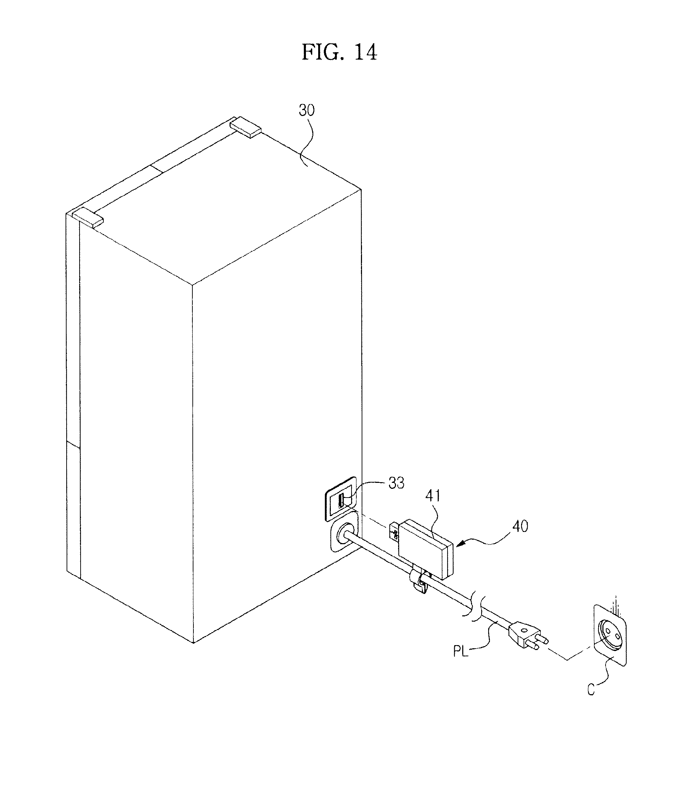

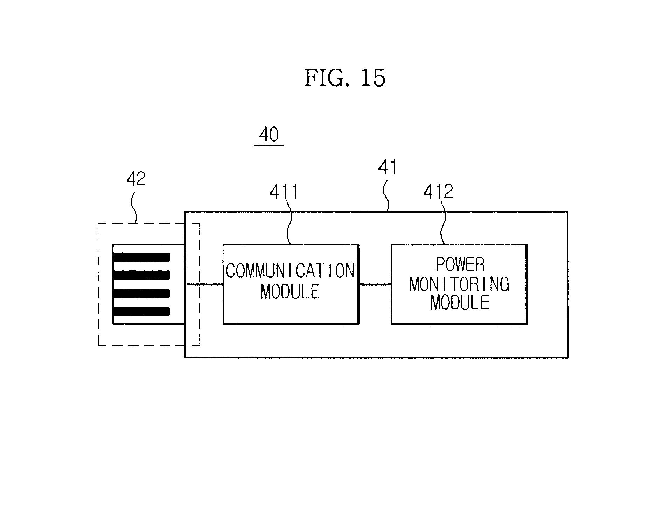

FIG. 14 is a structural diagram illustrating a power monitoring apparatus according to still another embodiment. FIG. 15 is a structural diagram illustrating a power monitoring apparatus according to still another embodiment.

Referring to FIG. 14, in the case where the communication port 33 of the household appliance 30 closely adheres to the power line, and the communication connector 42 of the power monitoring apparatus 40 is coupled to the communication port 33 while simultaneously being clipped to the power line of the household appliance or being picked up with tongs, the communication line (CL) between the communication module 411 and the power monitoring module 412 can be removed and the main frame 41 can include both the communication module 411 and the power monitoring module 412 (See FIG. 15).

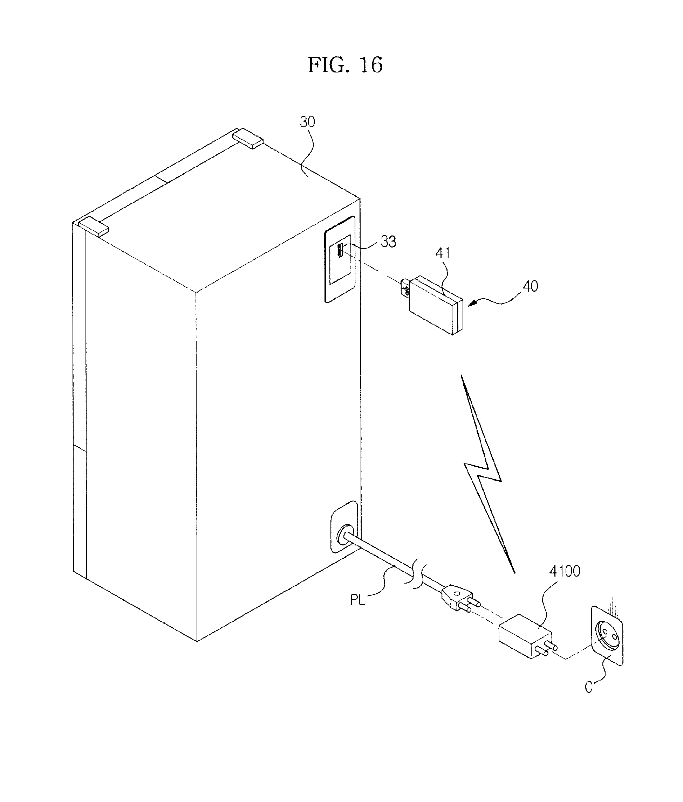

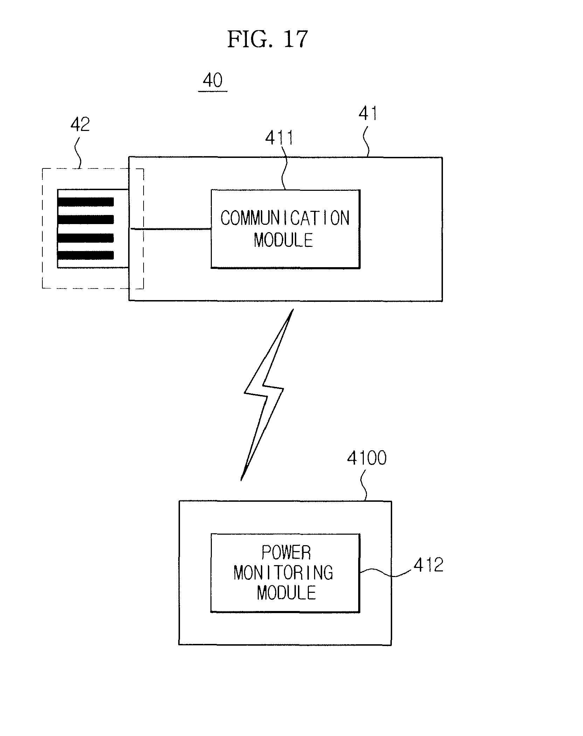

FIG. 16 is a structural diagram illustrating a power monitoring apparatus according to still another embodiment. FIG. 17 is a structural diagram illustrating a power monitoring apparatus according to still another embodiment.

Referring to FIGS. 16 and 17, the power monitoring apparatus 40 includes a main frame 41, a communication connector 42, and a communication module 411. The communication connector 42 is mounted to the front part of the main frame 41 such that it can be connected to the communication port 33 of the household appliance 30. The communication module 411 is connected to the communication connector 42 so as to communicate with the household appliance or the external device.

In addition, the power monitoring module 412 can wirelessly communicate with the communication module 411, and the main frame of the power monitoring module 412 is configured in the form of a wall socket. The wall socket can be coupled to the power plug of the power line of the household appliance 30. Therefore, power information of the household appliance 30 monitored (or measured) by the power monitoring module 412 is wirelessly transmitted to the communication module 411.

The power monitoring module 412 is configured to detect either current flowing in the power line of the household appliance 30 or voltage between both ends of the power source of the household appliance 30, such that it can monitor or measure power consumption of the household appliance 30. The power information monitored (or measured) by the power monitoring module 412 is wirelessly transmitted to the communication module 411.

In order to connect the power monitoring apparatus 40 to the household appliance 30, the communication connector 42 of the power monitoring apparatus 40 is coupled to the communication port 33 of the household appliance 30, and the power monitoring module 412 is coupled to the power plug of the household appliance 30 and at the same time is inserted into the socket.

By the above-mentioned connection, the household appliance 30 can communicate with an external part through the communication module 411 of the power monitoring apparatus 40, and the power monitoring module 412 of the power monitoring apparatus 40 is coupled to the power line of the household appliance 30, so that power consumption of the household appliance 30 can be measured.

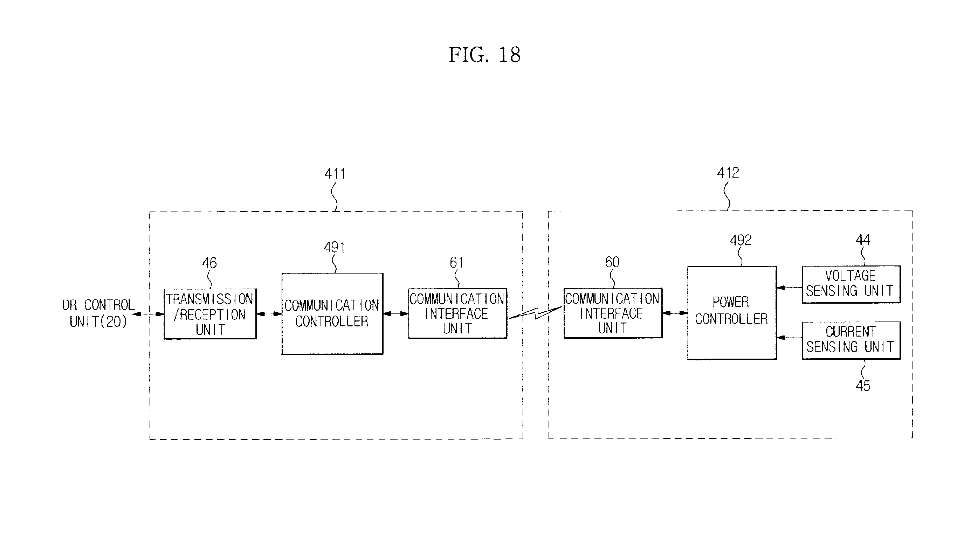

FIG. 18 is a control block diagram illustrating a power monitoring apparatus according to an embodiment.

Referring to FIG. 18, the power monitoring apparatus 40 includes a communication module 411, a power monitoring module 412, and a communication module 411.

The power monitoring module 412 includes a voltage sensing unit 44, a current sensing unit 45, a communication interface unit 60 and a power controller 492.

The voltage sensing unit 44 may detect a voltage between both ends of the power line of the household appliance 30.

The current sensing unit 45 may detect a current of the household appliance 30 using any one of two lines (AC- and AC+) of the power line of the household appliance 30. The current sensing unit 45 includes a current sensor composed of a magnetic core and a coil. The current sensor measures electromotive force (EMF) generated in a coil wound on the magnetic core, so that it can detect AC current on the basis of the measured EMF. Most current sensors are implemented as Conductivity-Temperature (CT) sensors.

In addition, the current sensing unit 45 includes a current sensor comprised of one or more resistors serially connected to any one of the AC power lines. This current sensor monitors (or measures) a voltage between both ends of the resistor, so that it can detect the AC current.

The communication interface unit 60 supports wired communication between the power controller 492 and the communication controller 491.

The power controller 492 detects a voltage between both ends of the power line (PL) of the household appliance 30 using the voltage sensing unit 44, and detects current flowing in any one of power lines (PLs) of the household appliance 30, so that it calculates power data of the household appliance. In this case, the power controller 492 does not detect known data from among current and voltage values, and detects only unknown data, so that it can calculate power data on the basis of the detected unknown result.

The communication module 411 includes a transmission/reception unit (also called a transceiver) 46, a communication interface unit 61, and a communication controller 491.

The transmission/reception unit 46 includes an antenna. The antenna may be implemented as a PCB-type antenna for increasing wireless communication reliability such as a WI-FI orZIGBEE.

The communication interface unit 61 supports wireless communication between the power controller 491 and the communication controller 492.

The power controller 491 transmits a power monitoring command to the power controller 492 upon receiving a power information request from the DR control unit 20, and receives power data from the power controller 492. The communication controller 491 transmits power information to the DR control unit 20 on the basis of the power data.

The communication controller 491 may demodulate an analog RF signal received through an antenna into a digital signal, or may modulate a digital signal to be transmitted into an analog RF signal.

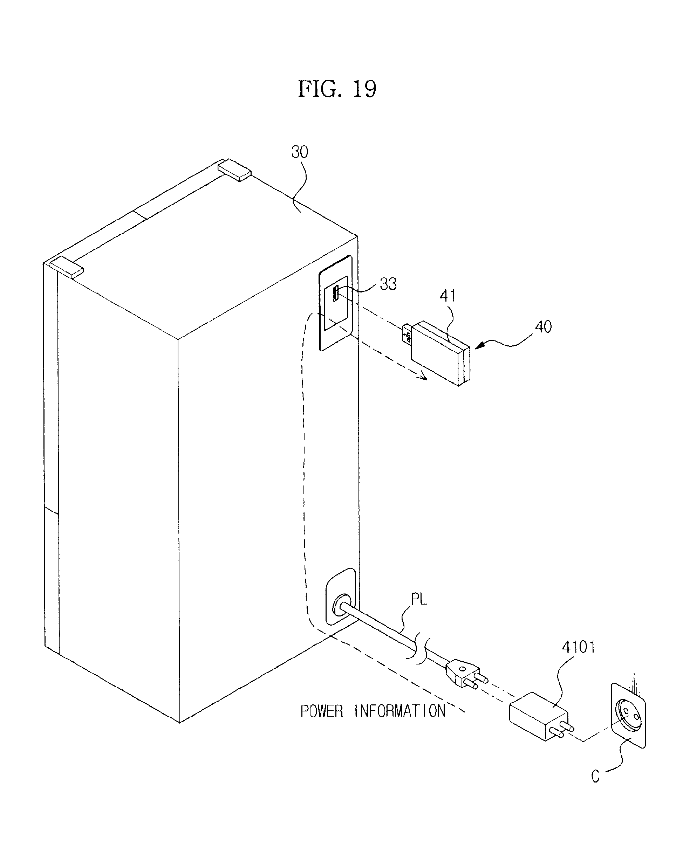

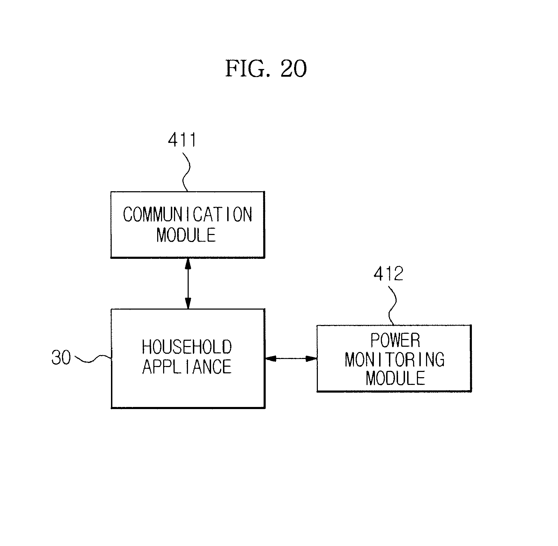

FIG. 19 is a structural diagram illustrating a power monitoring apparatus according to still another embodiment. FIG. 20 is a control block diagram illustrating a power monitoring apparatus according to an embodiment.

Power information of the household appliance 30 monitored (or measured) by the power monitoring module 412 may be wirelessly transmitted to the communication module 411 (See

FIG. 15). However, if PLC is used for power monitoring module 412 communication, power information may also be transmitted to the communication module 411 by wire after passing through the household appliance (See FIG. 19).

Referring to FIG. 20, the household appliance 30 receives power information of the household appliance 30 monitored (or measured) by the power monitoring module 412, and transmits the received power information to the communication module 411.

Meanwhile, if the communication module 411 is connected to the power monitoring module 412 through a wired interface, there is no problem in communication between the communication module 411 and the power monitoring module 412 because the communication module 411 is directly paired with the power monitoring module 412.

However, if the communication module 411 is connected to the power monitoring module 412 through a wireless interface, an unexpected problem may occur when the power monitoring module 412 transmits power information to the communication module 411. For example, provided that there are a plurality of household appliances, correct data communication between the communication module 411 and the power monitoring module 412 of each household appliance is required for transmission of power information of each household appliance. That is, the communication module 411 is always configured to be paired with the power monitoring module 412 such that it can communicate with the power monitoring module 412. In order to implement correct data communication of one pair of the modules, the data communication of the one pair of the modules must be separated from those of other pairs.

Under the condition that an arbitrary power monitoring module 412 attempts to transmit power information to its own paired communication module, the communication module needs to receive only its paired power information by wire or wirelessly. For example, the communication pairing method between the communication module and the power monitoring module is needed.

A unique number is mapped to each of the communication module 411 and the power monitoring module 412 in a manufactured product by a manufacturer of a manufactured product. A magnetic sensor or a proximity sensor may be mounted to the communication module 411 or the power monitoring module 412. Thus, if the communication module 411 moves close to the power monitoring module 412 along a predetermined direction, the magnetic sensor or the proximity sensor may recognize the unique number assigned to each module and then a communication link may be established between the modules. That is, unique numbers of the modules 411 and 412 are recorded in an address value region for data communication, such that pairing of data transmission/reception is completed. That is, it is possible to implement the pairing of data transmission/reception without using the addressing method such as a network protocol using an additional IP. For this purpose, the communication module 411 and the power monitoring module 412 need to be mechanically designed such that their appearances can be matched with each other.

Under the above-mentioned configuration, when communication between the power monitoring module 412 and the communication module 411 is registered, the power monitoring module 412 receives a unique number for communication from the corresponding communication module 411, and stores the received unique number. Communication between the power monitoring module 412 and the corresponding communication module 411 is achieved when the corresponding communication module 411 authenticates the unique number of the power monitoring module 412.

In addition, if the communication module 411 and the power monitoring module 412 having respective buttons are separated from each other and the user presses the button of the communication module 411, a light emitting diode (LED) blinks and at the same time the communication module 411 enters pairing mode. In this case, if the button of the power monitoring module 412 is pressed, the LED blinks and the power monitoring module 412 may be paired with the communication module 411 as necessary.

For example, in case of the air-conditioner, it is necessary for three elements (i.e., an indoor unit for a main room, an indoor unit for a living room, and an outdoor unit) to communicate with one another, one communication module 411 and three power monitoring modules 412 are needed. As a result, the simple contact-based pairing method and the pairing method between one communication module 4141 and several power monitoring modules 412 may be effectively used.

As is apparent from the above description, the power monitoring apparatus according to one aspect provides a communication function and a power metering function to an apparatus externally coupled to the household appliance, so that there is no need for the household appliance to include the power monitoring apparatus, resulting in reduction in production costs of the household appliance.

According to another aspect, the power monitoring apparatus for providing the communication function and the power metering function to the household appliance can be externally coupled to the household appliance. If a user wishes to use a demand management function, the user has only to connect the power monitoring apparatus to the household appliance, resulting in increased convenience of use.

In addition, according to still another aspect, the power monitoring apparatus externally connects a communication module configured to providing a household appliance with a communication function to a communication port of the household appliance, and connects a power monitoring module configured to providing the household appliance with a power metering function to a power line assigned to a power outlet for the household appliance, such that power monitoring can be achieved at the power line of the power outlet. As a result, an additional power line for power monitoring need not be constructed in the household appliance, such that a power port of the household appliance, a power connector of the power monitoring apparatus, and a power cable for interconnecting the power port and the power connector can be removed, and power monitoring is possible without changing the household appliance structure. In addition, the user can easily connect the power monitoring apparatus without the help of an installation engineer, such that the user's safety and convenience can be increased.

Although a few embodiments have been shown and described, it would be appreciated by those skilled in the art that changes may be made in these embodiments without departing from the principles and spirit of the invention, the scope of which is defined in the claims and their equivalents.

## Claims

1. A power monitoring apparatus comprising:
a power monitoring module to monitor power of a household appliance upon receiving a power source provided to the household appliance;
a communication connector coupled to a communication port of the household appliance; and
a communication module that is coupled to the communication connector so as to communicate with the household appliance or an external device, receives power information monitored by the power monitoring module, and transmits the received power information to the household appliance or the external device.

2. The apparatus according to claim 1, wherein the power monitoring apparatus includes a power connector coupled to a power port of the household appliance coupled to a power line of the household appliance, and
the power monitoring module is coupled to the power connector and monitors power of the household appliance upon receiving power provided to the power port.

3. The apparatus according to claim 2, wherein the power port and the power connector are connected through a power cable.

4. The apparatus according to claim 2, wherein the power port and the power connector are directly connected.

5. The apparatus according to claim 2, wherein the power monitoring module includes:
a voltage sensing unit to sense a voltage provided to the household appliance;
a current sensing unit to sense current provided to the household appliance; and
a power controller to monitor power of the household appliance on the basis of the voltage sensed through the voltage sensing unit and the current sensed through the current sensing unit.

6. The apparatus according to claim 5, wherein the voltage sensing unit detects a voltage between both ends of the power cable.

7. The apparatus according to claim 5, wherein the current sensing unit is a current sensor that includes a resistor serially connected to any one of the AC power lines present in the power cable so as to sense a current flowing in the any one of the AC power lines.

8. The apparatus according to claim 5, wherein the current sensing unit is a CT current sensor included in the any one of AC power lines so as to detect a current flowing in the any one of the AC power lines present in the power cable.

9. The apparatus according to claim 1, wherein the communication connector includes any one of a Universal Serial Bus (USB) connector, a Universal Asynchronous Receiver/Transmitter (UART) connector, a Serial Peripheral Interface (SPI) bus connector, an Inter Integrated circuit (12C) connector, and a 20-pin standard connector.

10. The apparatus according to claim 1, wherein the communication module includes:
a transmission/reception unit to transmit/receive information to/from an external device;
and
a communication controller to control information transmission/reception with the external device through the transmission/reception unit.

11. The apparatus according to claim 10, wherein:
the communication module includes:
a power source unit to provide power to the communication module;
a power manager to monitor a power status of the power source unit and provide power status information on the basis of the monitored power status; and
a switching unit to provide voltage to the power source unit or interrupt voltage from the power source unit, and
the communication controller controls the switching unit when electricity needs to be supplied to the power source unit on the basis of the power status information provided from the power manager, thereby charging the power source unit.

12. The apparatus according to claim 11, wherein the communication controller controls an operation for charging the power source unit before an operation of the household appliance is completed.

13. The apparatus according to claim 1, wherein the power monitoring module communicates with the communication module, monitors power provided to the household appliance through a power line of a power outlet for the household appliance, and transmits the monitored power information to the communication module.

14. The apparatus according to claim 13, wherein the power monitoring module is connected to the communication module by wire, such that the monitored power information is transmitted to the communication module by wire.

15. The apparatus according to claim 14, wherein the power monitoring module is configured in a form of tongs or clips so as to be connected to a power line of the household appliance.

16. The apparatus according to claim 15, wherein the power monitoring module includes a current transformer for sensing voltage flowing in any one of power lines of the household appliance.

17. The apparatus according to claim 13, wherein the power monitoring module and the communication module are integrated into one element, and the communication port of the household appliance is located close to the power line of the power outlet of the household appliance.

18. The apparatus according to claim 13, wherein the power monitoring module is wirelessly connected to the communication module so that the monitored power information is wirelessly transmitted to the communication module.

19. The apparatus according to claim 18, wherein the power monitoring module is configured in a form of a socket coupled to a power plug of the household appliance.

20. The apparatus according to claim 19, wherein the power monitoring module includes:
a current sensing unit to sense a voltage flowing in a power line of the household appliance; and
a voltage sensing unit to sense a voltage between both ends of the power line.

21. The apparatus according to claim 18, wherein the power monitoring module receives a unique number for communication with the communication module when communication between the power monitoring module and the communication module is registered, and stores the received unique number,
the communication between the power monitoring module and the communication module being achieved by the communication module that authenticates the unique number of the power monitoring module.

22. The apparatus according to claim 21, wherein the communication module includes a sensor for detecting approaching of the power monitoring module,
wherein if the approaching of the power monitoring module is detected by the sensor, the unique number is automatically transmitted to the power monitoring module.

23. The apparatus according to claim 22, wherein each of the communication module and the power monitoring module includes a button, and
if the buttons of the communication module and the power monitoring module are pressed, the communication module transmits the unique number and the power monitoring module stores the transmitted unique number.
